# EUROPEAN PATENT APPLICATION

(11) **EP 0 757 483 A2**
(43) Date of publication of application: **05.02.1997**
(21) Application number: 96305427.5
(22) Date of filing: 24.07.1996
(51) Int. Cl.: H04N 5/455

(54) **Digital I-Q converter circuit**

(30) Priority: 04.08.1995 GB 9516039
(71) Applicant: PLESSEY SEMICONDUCTORS LIMITED, Swindon, Wiltshire SN2 2QW (GB)
(72) Inventor: Cowley, Nicholas Paul, Wroughton, Wiltshire, SN4 9HZ (GB)
(74) Representative: Hoste, Colin Francis

(57) **Abstract**

A digital I-Q converter circuit produces, in a first mode of operation, quadrature I and Q baseband channels from a digitally modulated input signal. In a second mode of operation, circuitry relating to one of these channels is employed in the analogue demodulation of an angle-modulated input signal. A selection means selects the mode of operation required. The I- or Q-channel circuitry used for this dual purpose may be the mixer and local oscillator for that channel (and phase shifter, where the Q-channel is employed). The selection means may comprise switches for, in the second mode of operation: (a) inserting a loop filter into a feedback loop to the local oscillator, (b) inserting a limiting amplifier into the input circuit of the converter, and (c) removing a Costas loop to the oscillator fed from an external digital signal processor.

## Description

### DIGITAL I-Q CONVERTER CIRCUIT

The invention concerns a digital converter circuit for the processing of digitally modulated video signals, and especially, but not exclusively, a digital converter circuit for the processing of satellite video signals.

Historically, satellite transmissions of video signals have used wideband frequency modulation (FM) and a number of semiconductor manufacturers have developed a range of wideband FM demodulators to perform the demodulation function within the satellite receiver. Suitable demodulators include basic quadrature demodulators such as the SL1452, improved noise-rejection devices such as the SL1461 (a PLL demodulator), and dynamic bandwidth limiting quadrature demodulators such as the SL 1455, all of which are supplied by GEC Plessey Semiconductors.

More recently, digital techniques have been proposed as the modulation standard for future systems. These digital modulation schemes offer a number of significant and well-documented advantages over analogue modulation, e.g.: improved picture quality; ability to apply compression and so transmit a greater number of channels within the same bandwidth; ability to apply artifact-free scrambling for security purposes; ready adaptability to variable transmission rates, and applicability to different sources of data. A number of manufacturers have developed tuners for use in the digital environment based on either discrete I-Q demodulators or new integrated products such as the SL1710 from GEC Plessey Semiconductors.

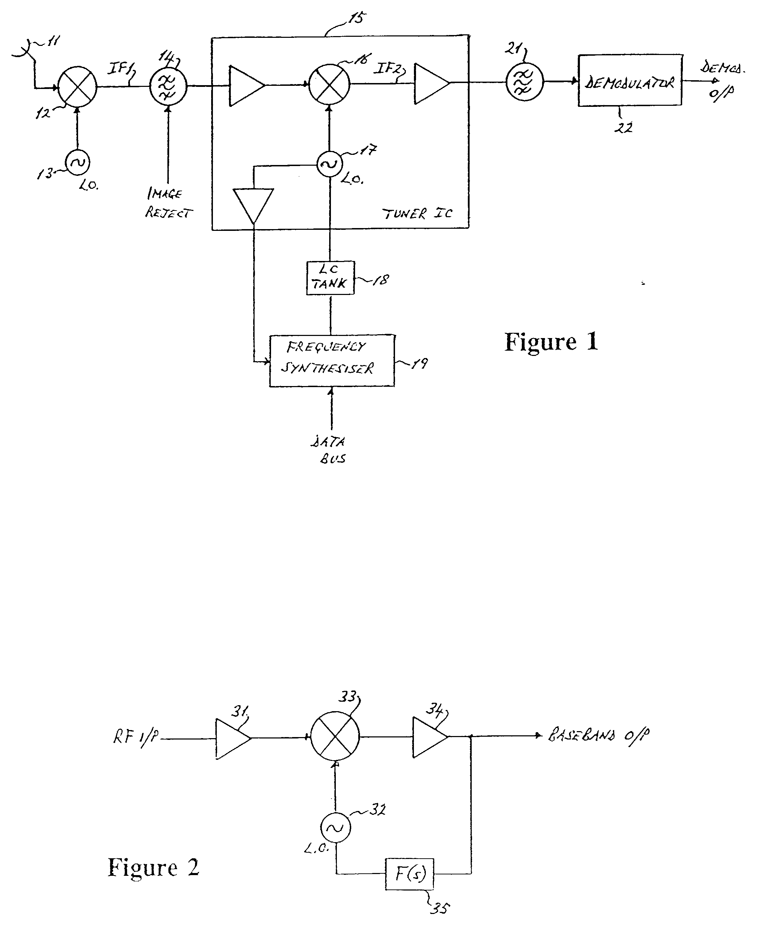

An example of a typical front-end and analogue demodulation arrangement is shown in Figures 1 and 2. In Figure 1 a signal received on an antenna 11 is down-converted in a mixer 12, fed from a local oscillator 13, to a first IF (IF1). This first IF signal is then subjected to image rejection in an image-reject filter 14, after which it is fed to an integrated tuner 15. The signal on the input of the tuner 15 is amplified then mixed in a mixer 16 with a second local oscillator signal from a local oscillator 17 to form a second IF, IF2. The tank 18 of the local oscillator 17 is connected to a frequency synthesiser, a data bus signal 20 on the input of the synthesiser 19 serving to set the resonant frequency of the tank 18, and hence the frequency of the local oscillator 17. The signal IF2 from the tuner IC 15 is taken to a SAW filter 21 to improve the signal-to-noise ratio of the signal, and is then demodulated in a demodulator 22.

Figure 2 shows the basic circuit arrangement of an analogue PLL demodulator which can serve as the demodulator 22 in Figure 1. The RF signal from the SAW filter 21 is first amplified in a preamplifier 31, then mixed with the output of a local oscillator 32 in a mixer 33. The output of the mixer 33 is then amplified in a loop amplifier 34 and fed back to the frequency-control input of the local oscillator 32 via a loop filter 35 having a transfer characteristic F(s). The centre frequency of the oscillator 32 is arranged to be equal to the IF frequency of the input signal entering the amplifier 31, i.e. IF2 in Figure 1, with the result that the output of the mixer 33 is the baseband frequency of the input signal.

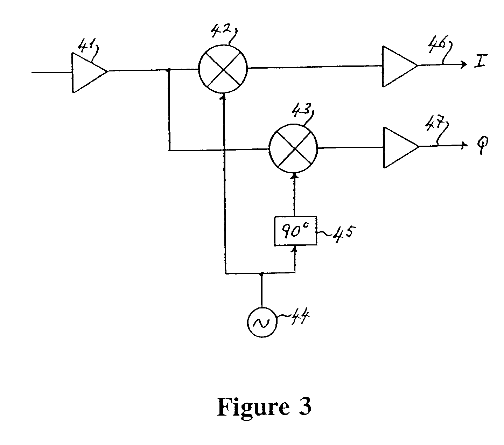

Figure 3 is a schematic circuit diagram of an I-Q converter (often loosely termed a "demodulator", in spite of the fact that actual demodulation takes place in a later stage) which can be used in place of the PLL demodulator to handle digitally modulated signals. In this case the IF2 signal from the SAW filter shown in Figure 1 is amplified in an amplifier 41 and then split into two quadrature channels by means of two mixers 42, 43 fed from local oscillator signals from a local oscillator 44. Mixer 42 receives a non-phase-shifted version of the local oscillator signal, while mixer 43 receives a 90°-shifted version of the same oscillator signal by way of 90° phase shifter 45. The outputs of the two mixers are amplified to form respective I and Q channel analogue outputs 46, 47. Outputs 46, 47 are then taken to respective A-D converters (not shown) whose digital outputs are processed in a digital signal processing stage (not shown) to extract the modulation information.

The present broadcasting environment is such that both analogue and digital signals are transmitted in parallel. This has, up to now, necessitated the use of separate tuners and demodulators in the same equipment, one for demodulation of the analogue signal, the other for demodulation of the digital signal.

It is an aim of the present invention to minimise the component count, and therefore the size and cost, of tuning and demodulation apparatus suitable for receiving and demodulating both analogue and digital signals.

According to the invention, there is provided a digital I-Q converter circuit for, in a first mode of operation, the processing of digitally modulated video signals prior to demodulation, comprising an I-channel forming means and a Q-channel forming means, one of said I-channel or Q-channel forming means constituting part of an analogue demodulation means for carrying out, in a second mode of operation, an analogue demodulation of angle-modulated video signals supplied to the converter as an input signal, and a selection means connected to said analogue demodulation means for selecting either one of said first and second modes of operation.

The advantage of this arrangement is that, by arranging for part of the I or Q-channel circuitry to double up as analogue demodulating circuitry, considerable savings in hardware can be achieved.

The I-channel or Q-channel forming means may comprise a mixer and a local oscillator feeding the mixer.

The analogue demodulation means may comprise a loop filter means switchably connected in a feedback loop between said mixer and a frequency-control input of said local oscillator, said selection means comprising a first switching means for switching said loop filter means into circuit when said second mode of operation is selected.

The I-channel or Q-channel forming means may comprise a linear amplifier connected to an output of said mixer and supplying, in said first mode of operation, an output signal of said channel, said loop filter means comprising an R-C network switchably connected by said first switching means between an input and an output of said linear amplifier.

The analogue demodulation means may comprise a limiting amplifier switchably connected into an input of the converter circuit, said selection means comprising a second switching means for switching said limiting amplifier into circuit when said second mode of operation is selected and bypassing said limiting amplifier when said first mode of operation is selected.

The selection means may comprise a third switching means connected to said frequency-control input of said local oscillator and serving to enable control of oscillator frequency by, in said second mode of operation, said feedback loop or by, in said first mode of operation, a Costas loop driven from an external digital signal processor.

An embodiment of the invention will now be described, by way of example only, with reference to the drawings of which:
Figure 1 is a schematic diagram of a tuner front-end and demodulator for a satellite receiving system;
Figure 2 is a schematic diagram of a known PLL analogue demodulator;
Figure 3 is a schematic diagram of a known digital I-Q converter;
Figure 4 is a schematic diagram of a digital I-Q demodulator according to the present invention.

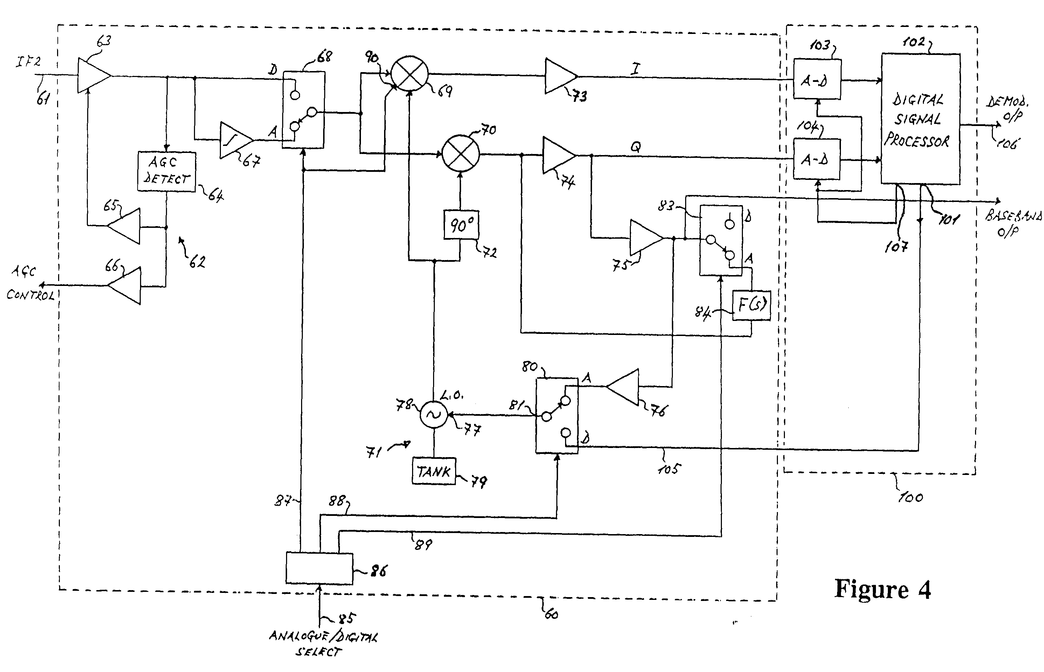

Referring now to Figure 4, a digital I-Q converter 60 receives on an input 61 the IF2 signal present at the output of the SAW filter 21 in Figure 1. The input 61 supplies an AGC stage 62 comprising a gain-controlled amplifier 63, an AGC detect block 64 for establishing an AGC threshold level, and further amplifiers 65 and 66. Amplifiers 65 and 66 feed the AGC control signal at the output of the AGC detect block 64 back to the gain-control input of the amplifier 63 and to similar circuitry in the tuner section 15 (see Figure 1), respectively.

The output of the amplifier 63 and also an amplitude-limited version of that output (see limiter 67) are taken to two respective terminals ("D" and "A") of an analogue changeover switch 68. The common terminal of the switch 68 is connected to the commoned inputs of mixers 69 and 70. Mixers 69 and 70 also receive a local oscillator input signal from a local oscillator stage 71, consisting of a local oscillator 78 and associated tank circuitry 79. Mixer 70 receives a phase-shifted version of the local oscillator signal, phase-shifting taking place in a 90° phase shifter 72. The I and Q channel outputs of the converter 60 are taken from the outputs of the mixers 69, 70 by way of linear amplifiers 73, 74, respectively.

In addition, the Q output from amplifier 74 is fed via series-connected linear amplifiers 75 and 76 to one terminal ("A") of an analogue changeover switch 80. A second terminal ("D") of the switch 80 is connected to an output 101 of a digital signal processing (DSP) chip 102 in a demodulation section 100. A second output 107 of the DSP chip is taken to the sampling inputs of two A-D converters 103, 104 in the same section. The common terminal of the changeover switch 80 is taken to a control input 77 of the local oscillator 78.

The A-D converters 103, 104 convert the analogue I and Q signals at the outputs of the amplifiers 73, 74 into digital values and inputs these to the DSP chip 102. The output 107 of the DSP chip 102 is used to trigger sampling in the A-D's 103 and 104 and the output 101 is used to vary the frequency of the local oscillator 78 via a Costas loop formed by the feedback line 105 supplying the control input of the oscillator 78. Thus, control is effected to ensure that sampling always occurs at the correct points on the analogue waveforms appearing on the outputs of the amplifiers 73 and 74. The demodulated digital input signal appears at an output 106 of the DSP chip 102.

A further analogue switch 83 is employed to connect the output of amplifier 75 with the input of amplifier 74 by way of a filter network 84 having a transfer function F(s). All three switches 68, 80 and 83 are controlled by an "analogue/digital" select input signal 85 by way of a signal router 86.

In operation, and assuming it is desired to demodulate a digital signal appearing at the input of the converter 60, an appropriate DC signal level is imposed on the select input 85. This then in turn imposes the appropriate DC levels on lines 87, 88 and 89 to switch the respective analogue switches 68, 80 and 83 to their "digital" positions shown as "D" on Figure 4. When this occurs, the Q-channel of the converter is made to function as a normal digital Q-channel since: (1) the amplified IF2 signal at the input of the converter 60 is taken directly to the inputs of the mixers 69, 70 - the signal is not limited; (2) the Costas loop 95 is completed, and (3) the filter 84 is taken out of circuit.

In contrast to this, when the converter 60 is required to demodulate analogue signals at its input 61, a different DC signal level is placed on the input 85 so that the switches 68, 80 and 83 switch over to their "analogue" positions marked "A". When this occurs, the Q-channel of the converter 60 is transformed into a PLL demodulator circuit since: (1) the limiting amplifier 67 is put into circuit in front of the mixers 68, 70 - this is required to improve the signal-to-noise ratio of the PLL demodulator; (2) the filter 84 is put into circuit across the amplifiers 74, 75 to provide the necessary filtering for the PLL, and (3) the Costas loop 95 is broken. In addition, the DC signal appearing on line 87 can be used, if required, to disable the I-channel mixer 69 via an input 90.

The baseband output can be extracted from the output of amplifier 75, as shown in Figure 4, or alternatively from the output of amplifier 73 or 74.

The switching block 83 could take the form of a multiway switch for selecting one of a number of filter F(S) settings, so simplifying the set-up of different loop parameters for more than one analogue application.

## Claims

1. A digital I-Q converter circuit for, in a first mode of operation, the processing of digitally modulated video signals prior to demodulation, comprising an I-channel forming means and a Q-channel forming means, one of said I-channel or Q-channel forming means constituting part of an analogue demodulation means for carrying out, in a second mode of operation, an analogue demodulation of angle-modulated video signals supplied to the converter as an input signal, and a selection means connected to said analogue demodulation means for selecting either one of said first and second modes of operation.

2. A digital I-Q converter circuit as claimed in Claim 1, in which said I-channel or Q-channel forming means comprises a mixer and a local oscillator feeding said mixer.

3. A digital I-Q converter circuit as claimed in Claim 2, in which the analogue demodulation means comprises a loop filter means switchably connected in a feedback loop between said mixer and a frequency-control input of said local oscillator, said selection means comprising a first switching means for switching said loop filter means into circuit when said second mode of operation is selected.

4. A digital I-Q converter circuit as claimed in Claim 3, in which said I-channel or Q-channel forming means comprises a linear amplifier connected to an output of said mixer and supplying, in said first mode of operation, an output signal of said channel, said loop filter means comprising an R-C network switchably connected by said first switching means between an input and an output of said linear amplifier.

5. A digital I-Q converter circuit as claimed in Claim 3 or Claim 4, in which the analogue demodulation means comprises a limiting amplifier switchably connected into an input of the converter circuit, said selection means comprising a second switching means for switching said limiting amplifier into circuit when said second mode of operation is selected and bypassing said limiting amplifier when said first mode of operation is selected.

6. A digital I-Q converter circuit as claimed in Claim 5, in which the selection means comprises a third switching means connected to said frequency-control input of said local oscillator and serving to enable control of oscillator frequency by, in said second mode of operation, said feedback loop or by, in said first mode of operation, a Costas loop driven from an external digital signal processor.
